Europäisches Patentamt

European Patent Office

Office européen des brevets

(19)

(11) Publication number: **0 138 438**
A2

# EUROPEAN PATENT APPLICATION

(12)

(21) Application number: **84306501.2**

(22) Date of filing: **24.09.84**

(51) Int. Cl.⁴: **H 03 J 3/18, H 03 H 1/00**

(30) Priority: **13.10.83 FI 833732**

(43) Date of publication of application: **24.04.85 Bulletin 85/17**

(84) Designated Contracting States: **DE FR GB IT NL SE**

(71) Applicant: **SALORA OY, Salorankatu 5-7, SF-241 00 Salo (FI)**

(72) Inventor: **Murtojarvi, Simo, Haapatie 8, SF-24260 Salo (FI)**

(74) Representative: **Crawford, Andrew Birkby et al, A.A. THORNTON & CO. Northumberland House 303-306 High Holborn, London WC1V 7LE (GB)**

(54) **Filter circuit tunable to microwave frequency, and implementation of the same.**

(57) The specification relates to the circuitry of a filter tunable to microwave frequencies. The circuitry comprises two successive transverse branches of the same type, which are at each end connected to ground and each of which includes, connected in series, a fixed inductance (L1; L2), an adjustable inductance (L4; L5), a capacitance diode (D1; D2), and a high frequency by-pass, in which case the capacitance diode (D1; D2) is controlled by means of a DC signal and there is a coupling element, e.g. a series inductance (L3) between the input point and output point of the filter. It is possible to cover the frequency range 950 ... 1750 MHz by using economical Si capacitance diodes, by replacing the capacitor which serves in prior filters as a high-frequeny by-pass with a series resonance circuit, which preferably comprises a capacitance diode (D3; D4) and an adjustable inductance (L6; L7). The implementation of the circuitry by using a two-sided circuit card is also described.

- 1 -

Filter Circuit tunable to
microwave frequencies,and
implementation of the same.

The present invention relates to a filter circuit
tunable to microwave frequencies, the circuit comprising
at least two successive transverse branches of the same
type, of which each includes, connected in series, a first
inductance, which is fixed; a second inductance, which is
adjustable; a capacitance diode; and a high-frequency by-
pass, both ends of the series circuit being connected to
ground, in which case the capacitance of the capacitance
diode is controlled by means of a DC signal  and the input
of the circuit is between the fixed inductance and the
adjustable inductance of the first transverse branch and
its output respectively at the corresponding point on the
second transverse branch, and a suitable coupling element
possibly being inserted between the transverse branches.
The invention also relates to the practical implementation
of the circuitry by using a two-sided circuit card.

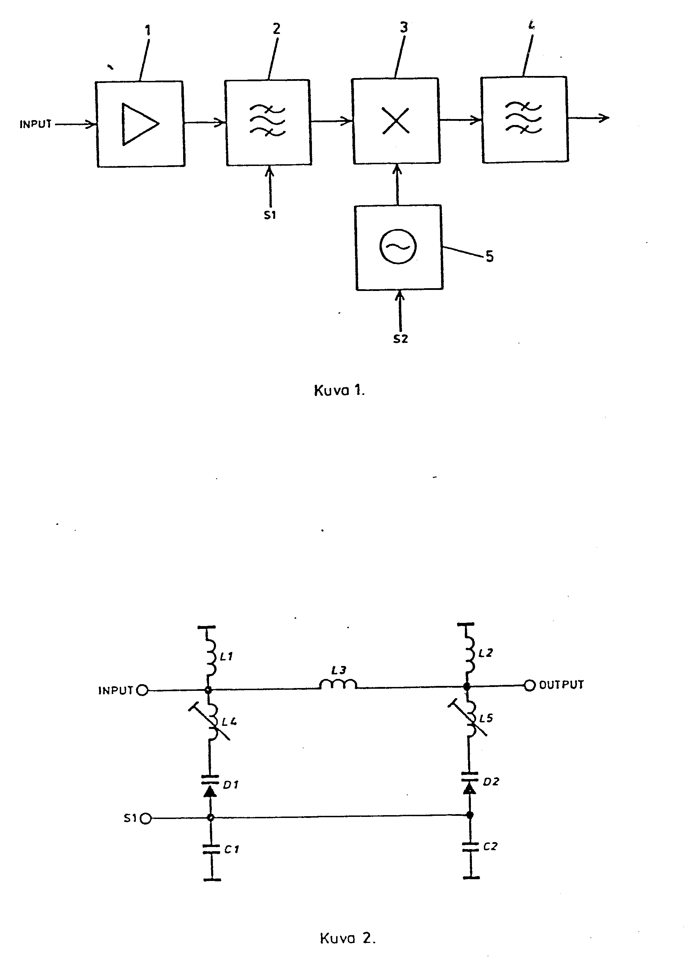

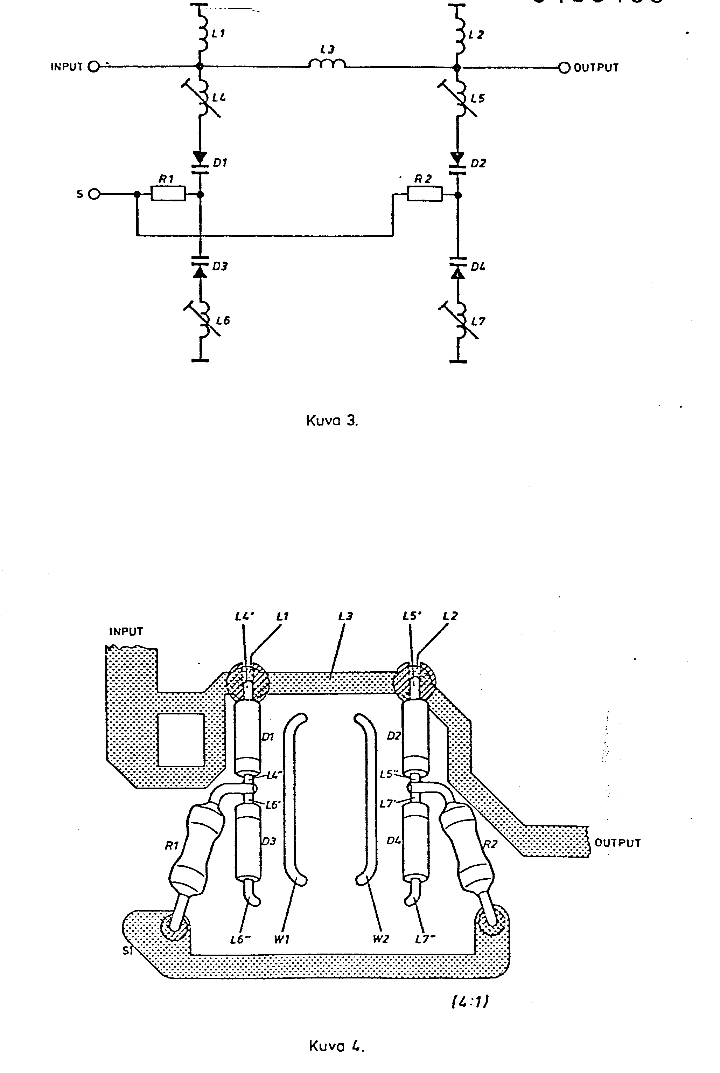

The frequency range 11.7 ... 12.5 GHz has been
reserved, by international conventions, as the transmission
frequency range for public broadcasting satellites.  In the
so-called external unit, situated in connection with the
receiving antenna, the original frequency range is converted
to a frequency band of 950 ... 1750 MHz.  A signal within
this frequency band is passed along a cable to the so-called
internal unit; an overall block diagram of its prestages is presented in Figure 1.    The signal is introduced into the amplifier 1 and passed further to the tunable band-pass filter 2, which is controlled by means of DC signal S1. The filtered signal is passed to the mixer 3, in which it is mixed with the frequency coming from the tunable oscillator 5 in such a way that the result obtained is a signal at an average frequency of 134 MHz, which is band-pass filtered in the block 4 before further processing. The invention also relates to the implementation of the filter 2.

Figure 2 depicts the basic circuitry of a tunable two-stage band-pass filter.    In the Figure D1 and D2 are capacitance diodes the capacitances of which are controlled by means of DC signal S1.    Capacitors C1 and C2 are by-pass capacitors, which isolate the control voltage from ground. L1, L2, L3, L4 and L5 are inductances.    The circuitry has been applied in TV channel selectors within a frequency range of 47 ... 860 MHz; channel selector MTS 200/1 of GTE Sylvania, described in publication GTE T.B.No. 24/1980, can be mentioned as an example.

The application, within a frequency range of 950 ... 1750 MHz, of the circuitry described above will lead, however, to the difficulties described below.    It is the function of by-pass capacitors C1 and C2, in addition to isolating the DC control voltage from ground, also to connect the signal of rf-frequency to ground.    At frequencies around 1000 MHz the series inductance of the capacitor produces, relative to ground, a high inductive reactance, which reduces the resonance frequency of the filter.    Since the inductive reactance of the capacitor is high, the capacitances of the capacitance diodes D1 and D2 must respectively be low in order that the resonance frequency adjust to a sufficiently high value.

The tuning ranges of the Si capacitance diodes used in TV channel selectors are narrow-band at low capacitance values, and so the entire frequency range of 950 ... 1750 MHz cannot be covered when they are used. An adequate tuning range can be obtained by replacing the Si diodes with GAS diodes. The prices of the latter are, however, many times those of Si diodes.

The object of the present invention is to eliminate these problems and to provide for such a filter a circuitry which can be implemented by using economical Si capacitance diodes and which, nevertheless covers the entire frequency range of 950 ... 1750 MHz. In order to achieve this, the circuitry according to the invention is mainly characterized in that the high-frequency by-pass is made up of a series resonance circuit, the resonance frequency of which is preferably the same as the resonance frequency of the two first inductances of the transverse branch, and of the capacitance diode.

The series resonance circuit is preferably made up of a capacitance diode and an adjustable inductance.

The invention and its other characteristics and details are described below in greater detail in the form of an example and with reference to the accompanying drawings, in which

Figure 1 depicts the already described block diagram of the prestages of the internal unit of the receiving antenna,

Figure 2 depicts the conventional band-pass filter belonging to the block diagram,

Figure 3 depicts a circuit diagram of the circuitry according to the invention,

Figure 4 depicts one implementation of the circuitry on a circuit card, and

Figure 5 depicts the frequency response of the filter according to the invention.

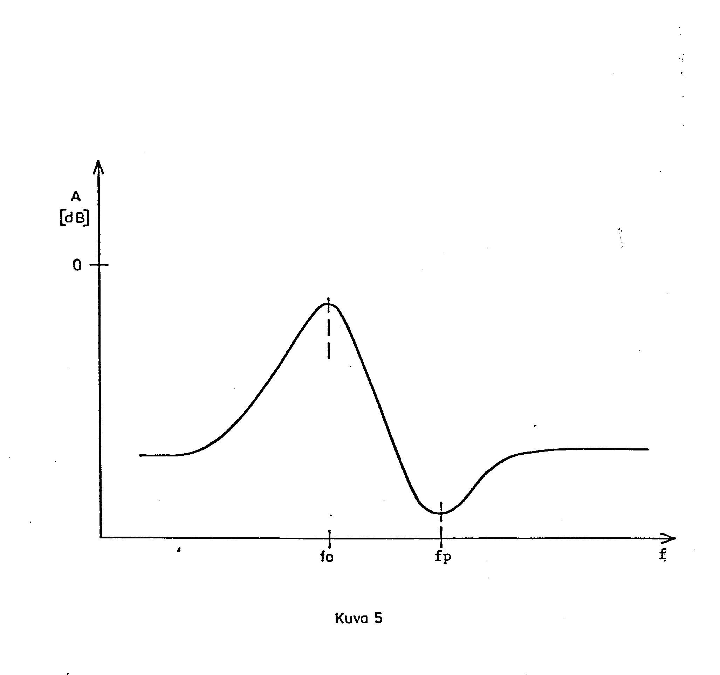

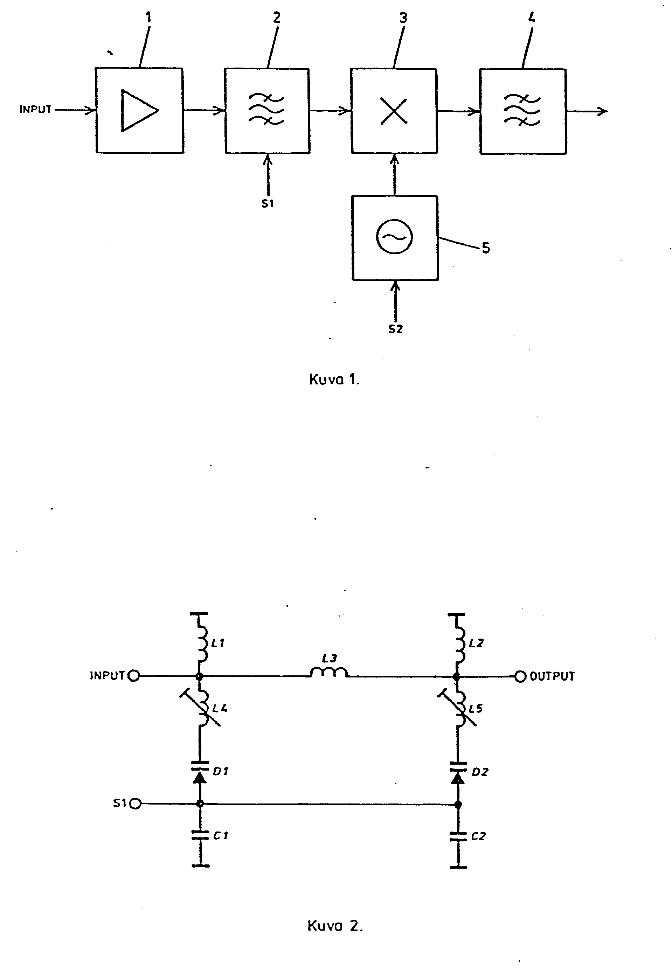

The circuitry according to the invention is thus shown in Figure 3. In it the components corresponding to Figure 2 are indicated by the same references as in Figure 2.    It is essential to the invention that the by-pass capacitors C1 and C2 have been replaced with series resonance circuits D3-L6 and D4-L7.   The resonance frequencies of these circuits have been selected by means of the component values to be the same as the resonance frequencies of circuits L1-D1-L4 and L2-D2-L5.    The said resonance circuits cause the formation of a ground point relative to the rf-frequency at the medium frequency of the filter at a point between the capacitance diodes.    Since the inductive reactance of the circuit remains low, it is possible to use as the capacitance diodes high-capacitance Si diodes, the tuning range which enables the entire frequency range of 950 ... 1750 MHz to be used as the control range of the medium frequency of the filter.

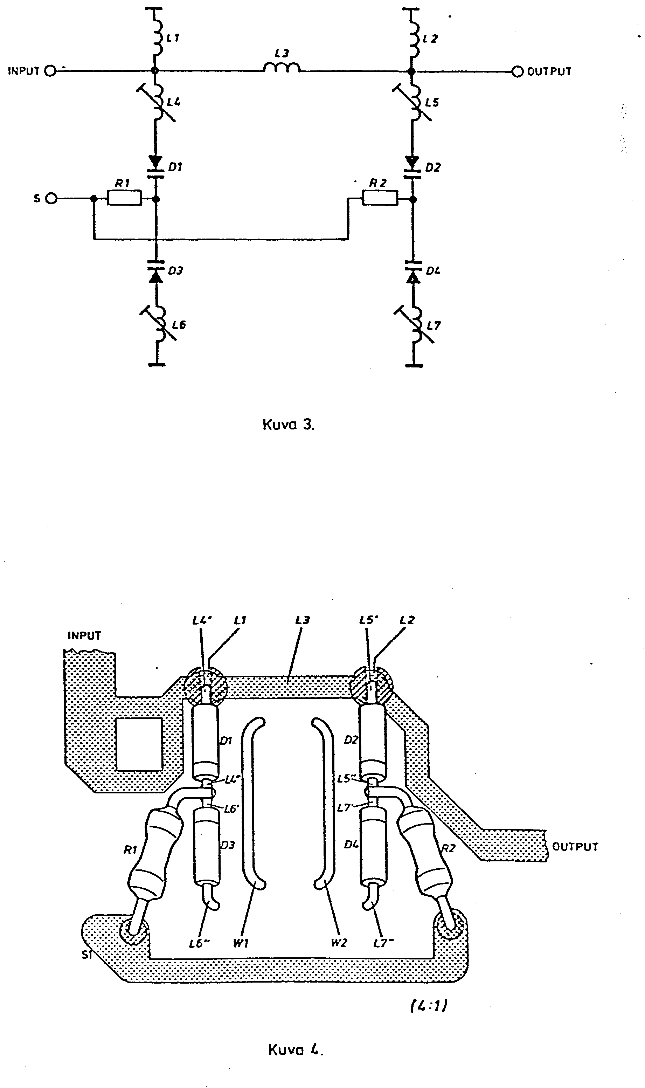

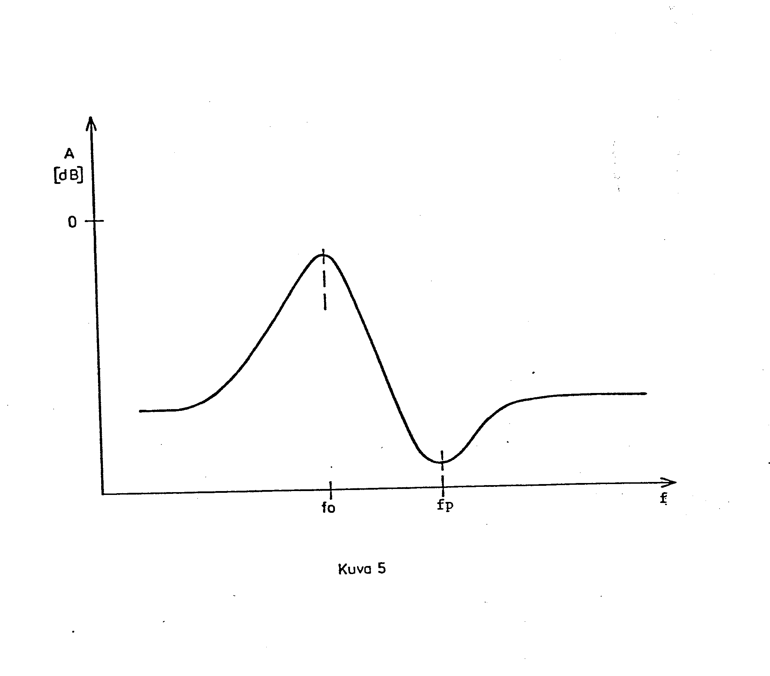

When the circuitry according to the invention is dimensioned suitably, an effective attenuation of the mirror frequency fp is also achieved by means of it.    When the ratio of the values of inductances L1 and L4 is selected suitably, the series resonance frequency of the circuit L4-D1-D3-L3 is somewhat above the medium frequency fo of the filter, and it also follows the mean frequency when the tuning is adjusted.    The frequency response of the filter becomes that in Figure 5.

The practical implementation of the circuitry according to the intention is presented in Figure 4.    The circuitry is implemented on a two-side circuit card in such a way that the foil on the lower side of the circuit card forms in the main an uninterrupted ground level.    In Figure 4 the foil area of the lower side and the foil-free area of the top side are indicated by the blank area.    The foils on the top side are indicated by dotting and the foil-free areas of the lower side by oblique shading.    The circuit components corresponding to the circuit diagram of Figure 3 are indicated in Figure 4.    Inductances L1 and L2 have

been implemented by means of foils on the lower side of the circuit card and so is inductance L3 on the top side of the circuit card. Inductances L4, L5, L6 and L7 are made up of the conductors of the capacitance diodes in such a way that they are each divided into two parts. For example, inductances L4' and L4" correspond to inductance L4, inductances L5' and L5" correspond to inductance L5, etc. The points between the diodes are connected together in air above the circuit card, and the resistors R1 and R2 are also connected to them. It is obvious that these connecting points also can be fixed to the card, whereby the fixing point is isolated from the inducting foil area. Components W1 and W2 in Figure 4 are tuning wires which are connected to ground at both ends. By changing the bend of the wires it is possible to affect the conductor inductances of the diodes and thereby also the operating frequencies of the filter.

CLAIMS .

1.          A filter circuit tunable to microwave frequencies, the circuitry comprising two successive transverse branches, each of which includes, connected in series, a first inductance (L1; L2), which is fixed; a second inductance (L4; L5), which is adjustable; a capacitance diode (D1; D2); and a high-frequency by-pass, both ends of the series circuit being connected to ground, in which case the capacitance of the capacitance diode (D1; D2) is controlled by means of a DC signal (S) and the input of the circuit is between the fixed inductance (L1) and the adjustable inductance (L4) of the first transverse branch and its output respectively at the corresponding point on the second transverse branch (L2; L5), characterized in that the high-frequency by-pass is made up of a series resonance circuit (D3, L6; D4, L7).

2.          A filter circuitry according to claim 1, characterized in that the resonance frequency of the series resonance circuit (D3, L6; D4, L7) is essentially the same as the resonance frequency of the two first inductances (L1, L4; L2, L5) and the capacitance diode (D1; D2) of the transverse branch.

3.          A filter circuit according to claim 1 or 2, characterized in that the series resonance circuit is made up of a capacitance diode (D3; D4) and an adjustable inductance (L6; L7)

4.          A filter circuit according to any of claims 1 to 3, characterized in that a DC signal is connected to a point between the capacitance diodes (D1, D3; D2, D4) on each transverse branch via a series resistor (R1; R2).

5. A filter circuit according to claim 3 or 4, characterized in that it is implemented on a two-sided circuit card in such a way that the substantially uninterrupted lower-side foil of the circuit card constitutes the ground level, that on the top side there are placed the two capacitance diodes (D1, D3; D2, D4) of each transverse branch in series, and at a point between them there is connected a series resistor (R1; R2), in which case the lengths of wire remaining on each side of the connection point form part inductances (L4", L6'; L5", L7'), and that a series inductance (L3) of the circuit connected between the input point and the output point is implemented as a strip of foil on the top side.

Kuva 1.

Kuva 2.

0138438

Kuva 3.

(4:1)

Kuva 4.

Kuva 5

0138438

Kuva 1.

Kuva 2.

Kuva 3.

(4:1)

Kuva 4.

Kuva 5